# FASCICULE DE BREVET EUROPEEN

(11) **EP 0 467 799 B1**
(45) Date de publication et mention de la délivrance du brevet: **18.09.1996**
(21) Numéro de dépôt: 91420237.9
(22) Date de dépôt: 09.07.1991
(51) Int. Cl.: H02H 9/04, H01L 29/86

(54) **Dispositif de protection contre des surtensions et sa réalisation monolithique**
Einrichtung zum Schutz gegen Überspannungen und ihre monolithische Herstellung
Overvoltage protection device and monolithic manufacturing process thereof

(30) Priorité: 13.07.1990 FR 9009265
(43) Date de publication de la demande: 22.01.1992
(73) Titulaire: SGS-THOMSON MICROELECTRONICS S.A., F-94250 Gentilly (FR)
(72) Inventeur: Senes, Albert, F-37540 Saint Cyr sur Loire (FR)
(74) Mandataire: de Beaumont, Michel

(56) Documents cités:
- WO-A-90/03681
- FR-A- 2 382 789
- FR-A- 2 433 845
- FR-A- 2 598 043
- GB-A- 2 208 257

## Description

La présente invention concerne un dispositif de protection contre des surtensions et sa réalisation sous forme d'un composant semiconducteur monolithique.

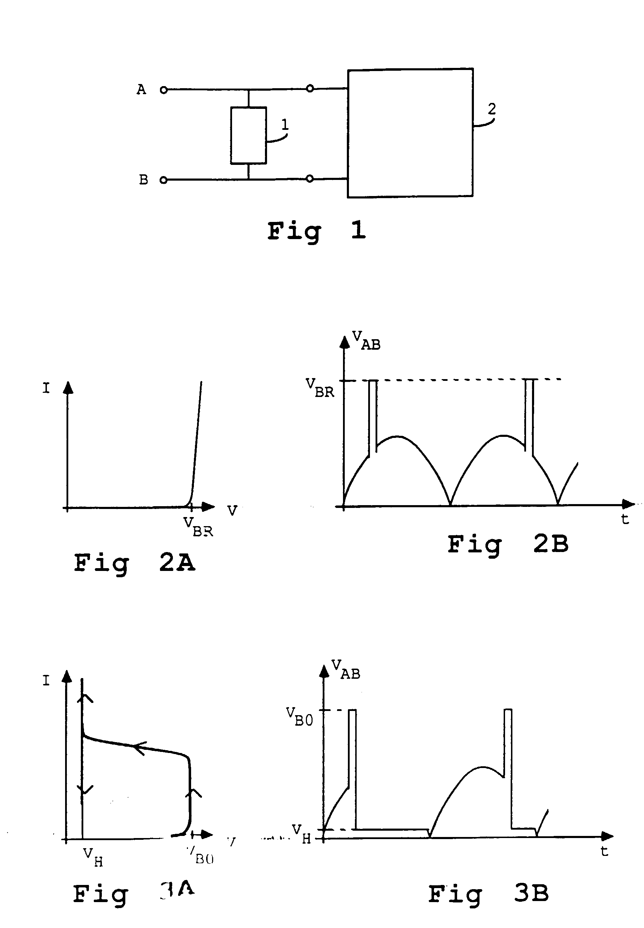

La figure 1 représente le montage habituel d'un dispositif de protection 1. Etant donné une tension d'alimentation disponible entre des bornes d'entrée A et B, et un circuit électronique à protéger 2, le dispositif de protection est disposé entre les bornes d'entrée A et B.

Deux types principaux de dispositifs de protection sont couramment utilisés.

Une premier type de dispositif de protection, par exemple une diode zener, est destiné à écrêter des impulsions de surtension survenant entre les bornes A et B. Ce composant présente une caractéristique du type illustré en figure 2A, à savoir que, dès que la tension à ses bornes dépasse une certaine valeur, appelée tension de claquage ou tension d'avalanche V_{BR} de la diode, le courant croît à tension sensiblement constante. Ainsi, comme le représente la figure 2A, des impulsions P1 et P2 venant se rajouter à un tension d'alimentation telle qu'une tension alternative redressée double alternance sont écrêtées et, dès la fin de l'impulsion, l'alimentation normale continue à être présente aux bornes du dispositif 2 à protéger.

Une deuxième type de dispositif de protection, tel qu'un thyristor à déclenchement par avalanche présente la caractéristique illustrée en figure 3A. Dès que la tension appliquée à ce dispositif dépasse une valeur V_{BO}, dite tension de retournement, le dispositif devient conducteur et la tension à ses bornes chute à une valeur très faible. Le dispositif reste ensuit à l'état conducteur tant que le courant d'alimentation n'est pas réduit à la valeur inférieure à un courant de maintien I_{H}. A titre d'exemple, la tension V_{BO} peut être de l'ordre de quelques centaine de volts et la tension V_{H} de l'ordre de la dizaine de volts. L'effet d'un tel dispositif de protection sur une tension alternative redressée double alternance est illustré en figure 3B. On voit qu'à partir de l'impulsion P1, l'alimentation du dispositif 2 est coupée pour ne remonter que lors de l'alternance suivante.

Chacun des dispositif de protection décrit précédemment présente des avantages et des inconvénients.

L'inconvénient principal des dispositifs de type diode zener est que, quant les impulsions deviennent de longue durée, un courant notable circule pendant la durée de l'impulsion dans la diode qui présente une tension élevée à ses bornes (de l'ordre de 400 volts par exemple pour un dispositif de protection du réseau) et qu'en conséquence la diode s'échauffe. Il faut alors prévoir des diodes de grande dimension et donc d'un coût élevé.

L'inconvénient principale des dispositif de type thyristor à avalanche est que, après chaque surtension, l'alimentation est interrompue jusqu'à remise à zéro de la tension d'alimentation. Il en résulte des disfonctionnements pour le dispositif à protéger quine reçoit plus d'alimentation ou qui doit comprendre une capacité réservoir d'entrée importante pour pallier ces chutes de tension. Malgré cet inconvénient, on est amené à utiliser des dispositifs de protection de ce type dès que les surtensions sont susceptibles d'être d'énergie (amplitude ou durée) importante.

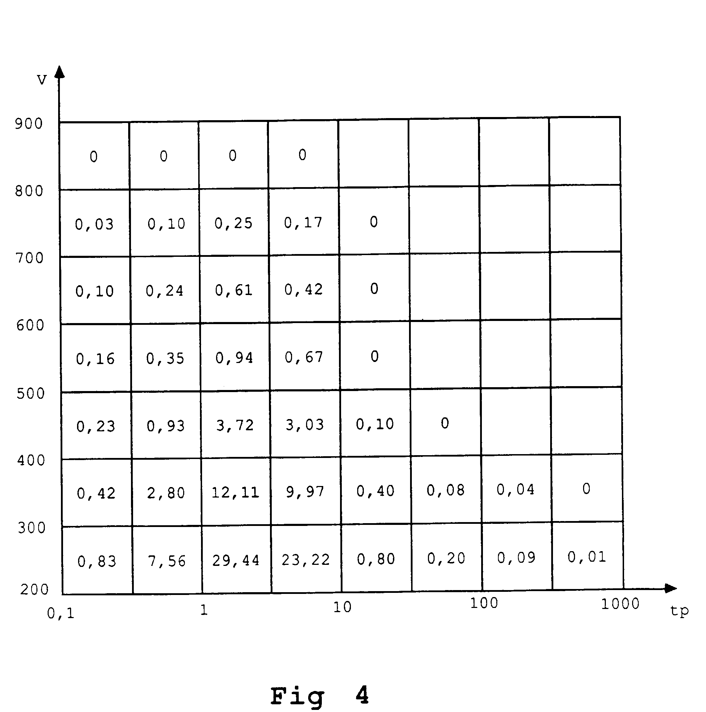

Or en pratique, le problème se pose de façon quelque peu différente. En effet, la figure 4 illustre le résultat d'une étude statistique effectuée sur des lignes d'abonnés en Europe. Cette étude correspond à l'observation pendant 112 jours d'une ligne d'abonné et révèle l'apparition de 1009 surtensions. Plus particulièrement, la figure 4 est un diagramme montrant la probabilité d'apparition de surtensions d'amplitude et de durée données. Le diagramme de la figure 4 montre que 29,44 % des surtensions observées ont une valeur comprise entre 200 et 300 volts au-dessus de la tension normale du réseau et une durée entre 1 et 3 microsecondes alors que 0,42 % des surtensions observées seulement ont une valeur comprise entre 600 et 700 V et une durée comprise entre 3 et 10 microsecondes.

On peut classer les surtensions observées en deux catégories, celles à forte énergie et celles à faible énergie. Les surtensions à forte énergie sont caractérisée soit par une longue durée (par le supérieure à 10 microsecondes) même si leur amplitude est relativement faible (par exemple inférieure à 300 volts), soit par une forte amplitude (par exemple supérieure à 600 volts) même si leur durée est relativement courte (par exemple inférieure à une microseconde). Les surtensions à faible énergie présentent les caractéristiques complémentaires. Dans l'exemple ci-dessus, ce sont celles qui ont une amplitude inférieure à 600 volts et une durée inférieure à 10 microsecondes.

En se reportant au diagramme de la figure 4, on voit que les impulsions de faible énergie apparaissent dans 96,38 % des cas observés tandis que les surtensions de forte énergie ne représentent que 3,62 % des cas. Néanmoins, classiquement, et pour tenir compte des surtension à forte énergie, on ne peut se contenter d'un dispositif de protection à écrêtage tel qu'une diode zener et il convient d'avoir recours à un dispositif coupe-circuit du type thyristor à avalanche.

Un objet de la présente invention est de prévoir un dispositif de protection fonctionnant en écrêtage pour des impulsions de surtension de faible énergie et en coupe-circuit seulement pour des impulsions de forte énergie.

Un autre objet de la présente invéntion est de prévoir une réalisation sous forme de circuit monolithique à semiconducteur d'un tel dispositif permettant un ajustage déterminé des caractéristiques relatives des divers composants du dispositif de protection.

Pour atteinre ces objets ainsi que d'autres, la présente invention prévoit un dispositif de protection contre des surtensions susceptibles de survenir entre deux bornes A et B comprenant, entre ces bornes, un thyristor à déclenchement par avalanche ayant une tension de retournement déterminée. Ce dispositif comprend en outre une diode zener montée directement en parallèle, tête-bêche, avec le thyristor, cette diode étant choisie pour que sa tension de seuil d'avalanche soit inférieure à ladite tension de retournement et que cette tension d'avalanche, en présence d'une surtension provoquant une résistance dynamique croissante, ne devienne supérieure à ladite tension de retournement que pour des surtensions présentant une durée ou une amplitude supérieure à un seuil prédéterminé.

Le dispositif selon la présente invention peut être réalise sous forme d'un composant semiconducteur monolithique comprenant un substrat semiconducteur de type N et comportant dans une première tranche verticale des couches propres à former un thyristor à déclenchement par avalanche et dans une deuxième tranche verticale des couches propres à former une diode zener, la face supérieure étant métallisée et court-circuitant l'anode de la diode zener et la cathode du thyristor et la face inférieure étant métallisée et court-circuitant la cathode de la diode zener et l'anode du thyristor, caractérise en ce que la jonction NP entre le substrat et la couche P supérieure dans laquelle se déclenche l'avalanche présente un gradient de concentration plus élevé dans la partie correspondant à la diode zener que dans la partie correspondant au thyristor.

Le document WO-A-90/03681 décrit un dispositif de protection comprenant un composant d'écrêtage de type diode Zener associé à un composant, de préférence à base d'une composition de calcogénure amorphe, présentant une résistance élevée pour des tensions faibles et une résistance faible pour de hautes tensions. Des moyens sont prévus pour provoquer le déclenchement de ce deuxième composant avec un certain retard par rapport au déclenchement du premier. Un tel dispositif présente l'inconvénient d'être complexe et difficilement intégrable.

Ces objets, caractéristiques et avantages ainsi que d'autres de la présente invention seront exposés plus en détail dans la description suivante de modes de réalisation particuliers faite en relation avec les figures joints parmi lesquelles :
les figures 1 à 4 destinées à illustrer l'état de la technique et le problème qui vise à résoudre la présente invention ont été décrite précédemment ;
la figure 5 représente un shéma de circuit d'un dispositif de protection selon la présente invention ;
la figure 6 représente des courbes courant/tension destinées à illustrer le fonctionnement du dispositif selon la présente invention ;
la figure 7 représente un mode de réalisation sous forme de circuit monolithique à semiconducteur d'un composant selon la présente invention ; et
la figure 8 représente une variante de réalisation monolithique d'un dispositif de protection selon la présente invention.

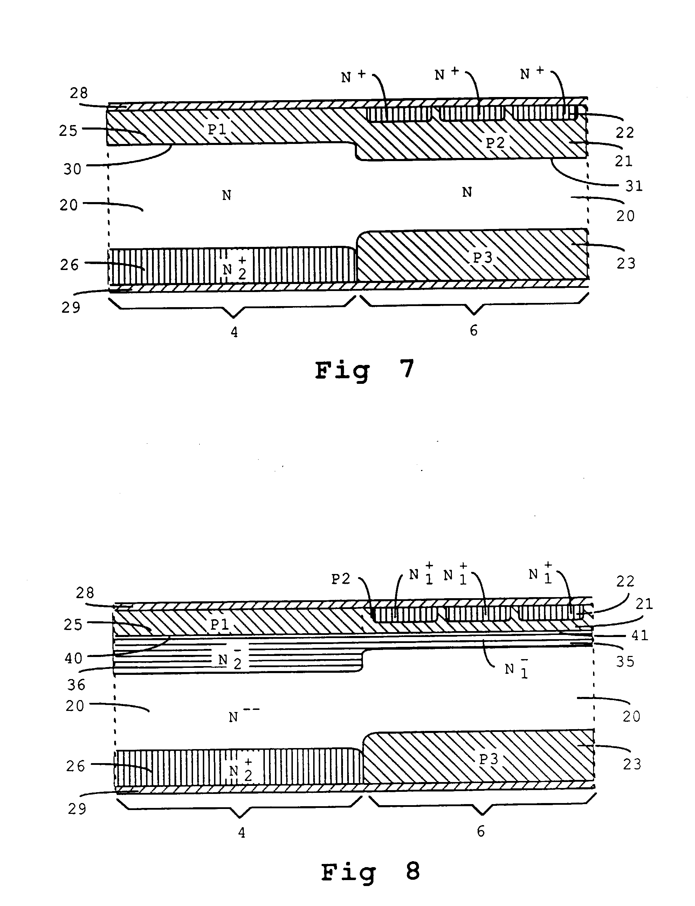

Dans les figure 7 et 8, on notera que, conformément à l'usage dans le domaine de la représentation des composants semiconducteurs, les épaisseur et dimensions latérales des diverses régions et couches ne sont pas représentées à l'échelle mais dilatées arbitrairement pour faciliter la lisibilité et le tracé des figures.

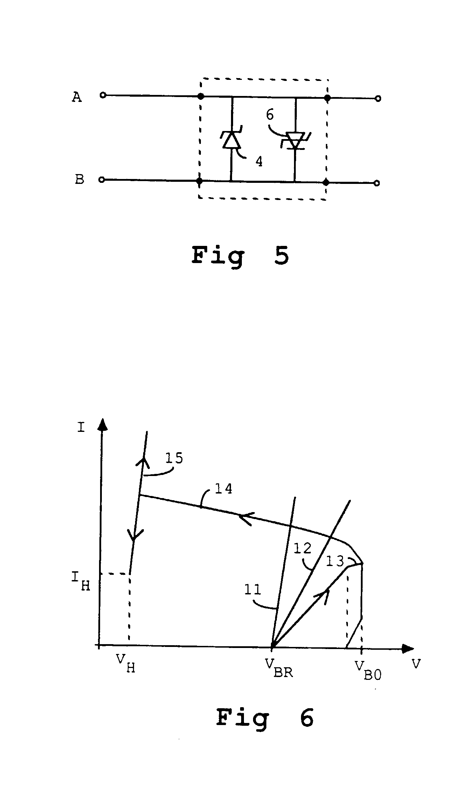

La figure 5 représente un dispositif de protection selon la présente invention. Il comprend, entre des bornes d'alimentation A et B, une diode zener 4 en anti-parallèle avec un thyristor 6 à déclenchement par avalanche, c'est-à-dire un thyristor sans gâchette se déclenchant quant la tension à ses bornes devient supérieure à une valeur déterminée.

La figure 6 illustre le fonctionnement d'un dispositif selon la présente invention. La diode zener présente une tension d'avalanche V_{BR} et, dès que la tension à ses bornes dépasse cette valeur V_{BR}, le courant croît rapidement tandis que la tension reste sensiblement constante. Toutefois, la diode zener présente une certaine résistance dynamique.

La présente invention utilise le fait que cette résistance dynamique est variable et dépend notamment de la température de la jonction zener. En présence d'un impulsion de longue durée, la diode s'échauffe et sa résistance dynamique croît. Dans la figure 6, la courbe 11 correspond au cas d'une impulsion de courte durée, la courbe 12 à une impulsion de durée moyenne et la courbe 13 à un impulsion de durée longue.

Le thyristor 6 est choisi pour que sa tension de retournement V_{BO} soit supérieure à la tension V_{BR} de la diode zener. La différence entre les valeurs V_{BO} et V_{BR} est telle que la tension V_{BO} est atteinte seulement pour des impulsions ralativement longues (courbe 13) ou pour des impulsions courtes mais intenses (prolongement non représenté de la courbe 12). Quand la tension V_{BO} est atteinte, un avalanche se produit dans le thyristor et apparaît le phénomène de retournement, c'est-à-dire que la tension aux bornes chute rapidement comme cela est indiqué par la courbe 14, pour atteindre une tension faible sensiblement égale à une valeur V_{H} comme cela est indiqué par la courbe 15. Ensuite, c'est seulement quand la tension d'alimentation décroît et que le courant devient inférieur à I_{H} que le thyristor 6 se bloque à nouveau.

On obtient ainsi un dispositif fonctionnant en écrêteur pour des impulsions de faibles énergie et en coupe-circuit pour des impulsions de forte énergie.

L'homme de l'art choisira la différence entre les valeurs V_{BO} et V_{BR} en fonction de la durée et/ou de l'amplitude limite des impulsion dont il veut se protéger. Il pourra par exemple choisir respectivement des valeurs de 450 et 400 volts ou de 500 et 450 volts...

Une façon de fixer avec précision la différence entre les tension V_{BR} et V_{BO} consiste à réaliser sous forme d'un composant monolithique la diode zener 4 et la thyristor à déclenchement par avalanche 6.

Un premier exemple de réalisation d'un tel composant monolithique est illustré en figure 7.

La partie droite de la figure 7 correspond au thyristor 6 et la partie gauche à la diode zener 4. Ce composant est fabriqué à partie d'un substrat semiconducteur 20 de type N.

Du côté thyristor, une couche 21 de type P et une couche de cathode ou d'émetteur 22 de type N munie classiquement de court-circuits d'émetteur sont formées au dessus du substrat. De l'autre côté du substrat 20, sur la face inférieure, est formée un couche d'anode 23 de type P.

Du côté diode, une couche d'anode 25 de type P est formée sur la face supérieure du substrat 20 et une couche de cathode 26 de type N⁺ sur la surface inférieure.

Une métallisation 28 recouvre la face supérieur du composant et constitue l'anode de la diode et la cathode du thyristor. Une méttalisation 29 recouvre la face inférieure du composant et constitue la cathode de la diode et l'anode du thyristor. La jonction qui détermine la mise en avalanche de la diode 4 est la jonction 30 entre le substrat 20 de type N et la couche 25 de type P. La jonction qui détermine la mise en avalanche du thyristor 6 est la jonction 31 entre le substrat 20 et la couche 21 de type P. Pour la diode 30 entre en avalanche avant thyristor, il convient que le gradient de concentration des impuretés dopantes soit plus élevé au niveau de la jonction 30 qu'au niveau de la jonction 31.

L'homme de l'art connaît de nombreux moyens d'obtenir une telle différence de gradients de concentration. L'un des moyen utilisables consiste à former par implantation d'abord la région 21 et à effectuer un premier recuit puis à former la région 25 et à effectuer un second recuit pendant lequel les atomes dopants dans la région 21 continueront à diffuser.

La structure illustrée en figure 7 est particulièrement simple à réaliser. Toutefois, ils est connu que la valeur des tensions d'avalanche dépendra fortement de la concentration du substrat 20. Or, cette concentration est relativement variable d'une plaquette à une autre et même dans des régions distinctes d'une même plaquette. On aura donc bien obtenu un écart choisi déterminé entre les niveaux d'avalanche des deux composants mais la valeur absolue de la tension d'avalanche de chacun de ces composants sera relativement variable.

Pour éviter cet inconvénient, on peut utiliser le mode de réalisation illustré en figure 8 dans lequel de mêmes couches et parties de couches qu'en figure 7 sont désignées par de mêmes références. Dans ce mode de réalisation, les couches 21 et 25 sont formées en une seule et même étape. Le gradient de concentration au niveau des jonctions est réalisé en faisant varier la concentration du côté N de chacune des jonctions que l'on veut mettre en avalanche. Pour cela, avant de former la couche 21-25, on forme à la surface du substrat des régions de type N plus fortement dopées 35 et 36, respectivement du côté thryristor et du côté diode et les jonctions auxquelles on s'intéresse sont les jonctions 41 entre les couches 21 et 35 et 40 entre les couches 36 et 25. Les régions 35 et 36 peuvent être formées ou bien en implantant des doses de dopant N différentes du côté diode et du côté thyristor et en procédant à un recuit ou bien, comme cela a été indiqué précédemment, en opérant en deux étapes c'est-à-dire en effectuant une première implantation suivie d'un recuit puis une deuxième implantation suivie d'un deuxième recuit. Par ce moyen, on peut régler avec précision les concentrations et les gradients de concentration au niveau des jonctions pour les couches et 36 et obtenir des composants présentant des valeurs de tension d'avalanche plus précises que dans le cas du mode de réalisation de la figure 7.

La présente invention a été exposée de façon générale et dans le cadre de modes de réalisation particuliers. L'homme de l'art pourra y apporter diverses variantes et modifications. Notamment, on a décrit ici un dispositif de protection unidirectionnel. La présente invention s'applique de même à des composants de protection bidirectionnels, les transformations et montages destinés à former des dispositifs de protection bidirectionnels à partir de dispositifs de protection unidirectionnels étant bien connus de l'homme de l'art.

## Revendications

1. Dispositif de protection contre des surtensions susceptibles de survenir entre deux bornes (A et B) comprenant, entre ces bornes, un thyristor à déclenchement par avalanche (6) ayant une tension de retournement (V_{BO}) déterminée, caractérisé en ce qu'il comprend en outre une diode zener (4) montée directement en parallèle, tête-bêche, avec le thyristor, cette diode étant choisie pour que sa tension de seuil d'avalanche (V_{BR}) soit inférieure à ladite tension de retournement et que cette tension d'avalanche, en présence d'une surtension provoquant une résistance dynamique croissante, ne devienne supérieure à ladite tension de retournement que pour des surtensions présentant une durée ou une amplitude supérieure à un seuil prédéterminé.

2. Composant semiconducteur monolithique mettant en oeuvre le dispositif selon la revendication 1 comprenant un substrat semiconducteur de type N (20) et comportant dans une première tranche verticale des couches (21, 22, 23) propres à former un thyristor à déclenchement par avalanche (6) et dans une deuxième tranche verticale des couches (25, 26) propres à former une diode zener (4), la face supérieure (28) étant métallisée et court-circuitant l'anode de la diode zener et la cathode du thyristor et la face inférieure (29) étant métallisée et court-circuitant la cathode de la diode zener et l'anode du thyristor, caractérisé en ce que la jonction NP entre le substrat (20) et la couche P supérieure (21, 25) dans laquelle se déclenche l'avalanche présente un gradient de concentration plus élevé dans la partie correspondant à la diode zener que dans la partie correspondant au thyristor.

3. Composant selon la revendication 2, caractérisé en ce que, dans la surface supérieure du substrat, est formée, dans la partie correspondant au thyristor, une première région P (21) et dans la partie correspondant à la diode une deuxième région P (25), la deuxième région P ayant un gradient de concentration plus élevé que la première.

4. Composant selon la revendication 2, caractérisé en ce que la face supérieure de substrat (20) comprend, sous la région P (21, 25) de base du thyristor et d'anode de la diode, respectivement, une première région N (35) à niveau de dopage plus élevé que le substrat au niveau du thyristor et une deuxième région N (36) à dopage plus élevé que la première au niveau de la diode.

## Patentansprüche

1. Schutzeinrichtung gegen Überspannungen, die dazu tendieren, zwischen zwei Versorgungssanschlüssen (A, B) aufzutreten, die zwischen den Anschlüssen einen avalanche- bzw. lawinengesteuerten Thyristor (6) mit einer vorbestimmten Kippspannung (V_{BO}) aufweist, dadurch **gekennzeichnet**, daß sie ferner eine Zenerdiode (4) direkt parallel und umgekehrt bzw. antiparallel mit dem Thyristor verbunden aufweist, wobei die Diode derart ausgewählt ist, daß ihre Avalanche- bzw. Durchbruchspannung (V_{BR}) kleiner als die Kippspannung ist, und daß ihre Durchbruchspannung, und zwar in der Anwesenheit einer Überspannung, die eine Erhöhung des dynamischen Widerstandswertes verursacht, höher als die Kippspannung wird, und zwar nur für Überspannungen mit einer Dauer oder Amplitude größer als eine vorbestimmte Schwelle.

2. Monolithisches Halbleiterbauelement, das die Einrichtung nach Anspruch 1 implementiert, die ein Halbleitersubstrat (20) vom N-Typ aufweist, und die ferner folgendes aufweist: in einem ersten vertikalen Teil Schichten (21, 22, 23), die geeignet sind einen avalanchegetriggerten Thyristor (6) zu bilden und in einem zweiten vertikalen Teil Schichten (25, 26), die geeignet sind, eine Zenerdiode (4) zu bilden, wobei die obere Oberfläche (28) metallisiert ist und die Anode der Zenerdiode und die Kathode des Thyristors kurzschließt, und wobei die untere Oberfläche (29) metallisiert ist und die Kathode der Zenerdiode und die Anode des Thyristors kurzschließt, dadurch **gekennzeichnet**, daß der NP-Übergang zwischen dem Substrat (20) und der oberen P-Schicht (21, 25), in dem die Lawine ausgelöst wird, einen höheren Konzentrationsgradienten in dem Teil, der der Zenerdiode entspricht, als in dem Teil, der dem Thyristor entspricht, besitzt.

3. Bauelement nach Anspruch 2, dadurch gekennzeichnet, daß in der oberen Oberfläche des Substrats in dem Teil, der dem Thyristor entspricht, eine erste P-Region (21) und in dem Teil, der der Diode entspricht, eine zweite P-Region (25) gebildet ist, wobei die zweite P-Region einen Konzentrationsgradienten höher als den ersten besitzt.

4. Bauelement nach Anspruch 2, dadurch gekennzeichnet, daß die obere Oberfläche des Substrats (20) unter der P-Region (21, 25), die der Basis des Thyristors bzw. der Anode der Diode entspricht, eine erste N-Region (35) mit einem Dotierniveau höher als das Substrat bei dem Thyristor, und eine zweite N-Region (36) mit einem Dotierniveau höher als die erste Region bei der Diode, aufweist.

## Claims

1. A protection device against overvoltages liable to occur between two supply terminals (A, B) comprising, between said terminals, an avalanche triggered thyristor (6) having a determined breakover voltage (V_{BO}), characterized in that it further comprises a zener diode (4) directly in parallel and reversibly connected with said thyristor, said diode being selected so that its avalanche voltage (V_{BR}) is lower than said breakover voltage and that said avalanche voltage, in the presence of an overvoltage causing an increase of the dynamic resistance gets higher than said breakover voltage only for overvoltages having a duration or amplitude higher than a predetermined threshold.

2. A monolithic semiconductor component implementing the device of claim 1, comprising an N-type semiconductor substrate (20) and comprising, in a first vertical portion, layers (21, 22, 23) adapted to form an avalanche triggered thyristor (6) and, in a second vertical portion, layers (25, 26) adapted to form a zener diode (4), the upper surface (28) being metallized and shorting the anode of said zener diode and the cathode of said thyristor, and the lower surface (29) being metallized and shorting the cathode of said zener diode and the anode of said thyristor, characterized in that the NP junction between said substrate (20) and the upper P layer (21, 25) wherein the avalanche triggered has a higher concentration gradient in the portion corresponding to the zener diode than in the portion corresponding to the thyristor.

3. The component of claim 2, characterized in that, in the upper surface of said substrate, is formed, in the portion corresponding to said thyristor, a first P region (21) and, in the portion corresponding to said diode, a second P region (25), said second P region having a concentration gradient higher than the first one.

4. The component of claim 2, characterized in that the upper surface of said substrate (20) comprises, under the P region (21, 25) corresponding to the base of said thyristor and the anode of the diode, respectively, a first N region (35) having a doping level higher than the substrate at said thyristor and a second N region (36) having a doping level higher than the first region at the diode.
